Europäisches Patentamt

European Patent Office

Office européen des brevets

(19)

(11) **EP 0 599 817 B1**

(12) **EUROPEAN PATENT SPECIFICATION**

(45) Date of publication and mention
of the grant of the patent:
**04.03.1998 Bulletin 1998/10**

(51) Int Cl.6: **H03H 17/06**

(21) Application number: **94101859.0**

(22) Date of filing: **23.12.1988**

(54) **Sampling frequency conversion method and apparatus**

Verfahren und Vorrichtung zur Umsetzung der Abtastfrequenz

Circuit et méthode pour convertir la fréquence d'échantillonage

(84) Designated Contracting States:
**CH DE FR GB LI**

(30) Priority: **29.12.1987 JP 332395/87**

(43) Date of publication of application:
**01.06.1994 Bulletin 1994/22**

(62) Document number(s) of the earlier application(s) in
accordance with Art. 76 EPC:
**88312325.9 / 0 323 200**

(73) Proprietor: **SONY CORPORATION**
**Tokyo 141 (JP)**

(72) Inventor: **Lagadec, Roger,**
**c/o Intellectual Property Div.**
**Shinagawa-ku, Tokyo 141 (JP)**

(74) Representative: **Cotter, Ivan John et al**
**D. YOUNG & CO.**
**21 New Fetter Lane**
**London EC4A 1DA (GB)**

(56) References cited:
**EP-A- 0 084 592      EP-A- 0 137 323**

• **GRUNDIG TECHNISCHE INFORMATIONEN vol. 31, no. 1/2 , 1984 , REGENSBURG (DE) pages 3 - 7 GLAAB 'Oversampling-Verfahren der Grundig Compact-Disc-Spieler'**
• **IEEE TRANSACTIONS ON ACOUSTICS, SPEECH & SIGNAL PROCESSING vol. ASSP-29, no. 2 , April 1981 , NEW YORK (USA) pages 155 - 162 E.B. HOGENAUER 'An economical class of digital filters for decimation and interpolation.'**

**Description**

This invention relates to sampling frequency converters for and methods of converting sampled input data having an input sampling frequency into sampled output data having an output sampling frequency. The invention finds particular use in, for example (but not exclusively), converting between sampling frequencies associated with different pulse code modulation (PCM) audio signal transmission systems.

Various PCM signal transmission systems have been proposed, many of which use different sampling frequencies to digitise and transmit audio signals. For example, the so-called compact disc system encodes an audio signal as a PCM signal recorded at a sampling frequency in the region of about 44.1kHz. As another example, a PCM processor is known in which an input audio signal is sampled at a frequency of 44.056kHz, this sampling frequency being used both to encode and decode a PCM audio signal. As yet another example, broadcast satellite systems are known to broadcast PCM audio signals in what has been designated the A mode at a sampling frequency of 32kHz and at what has been designated the B mode at a sampling frequency of 48kHz. Often, these different PCM samples having different sampling frequencies are to be interchanged such that a PCM signal produced by one system is to be transmitted over a communications system which uses a different PCM sampling frequency, and this signal is to be used eventually by yet another system employing a still different sampling frequency. Thus, the ability to convert PCM signals in particular, and sampled data in general, from one sampling frequency to another, is desirable.

A relatively simple, straightforward sampling frequency converter relies upon digital-to-analog conversion (DAC) of a PCM signal which, subsequently, is re-converted to yet another PCM signal at a desired sampling frequency. That is, an input PCM signal is converted to analog form and the converted analog signal is then sampled at the desired output sampling frequency in an analog-to-digital converter (ADC) to derive a PCM signal with the desired output sampling frequency. Such DAC-ADC processing is relatively complicated and expensive and giving rise to significant deterioration in signal quality. Thus, quantising errors are introduced in each analog-to-digital conversion and these quantising errors are cumulative when an input analog signal first is digitised, then converted to analog form and then re-digitised, all for the purpose of modifying the sampling frequency of the resultant PCM audio signal.

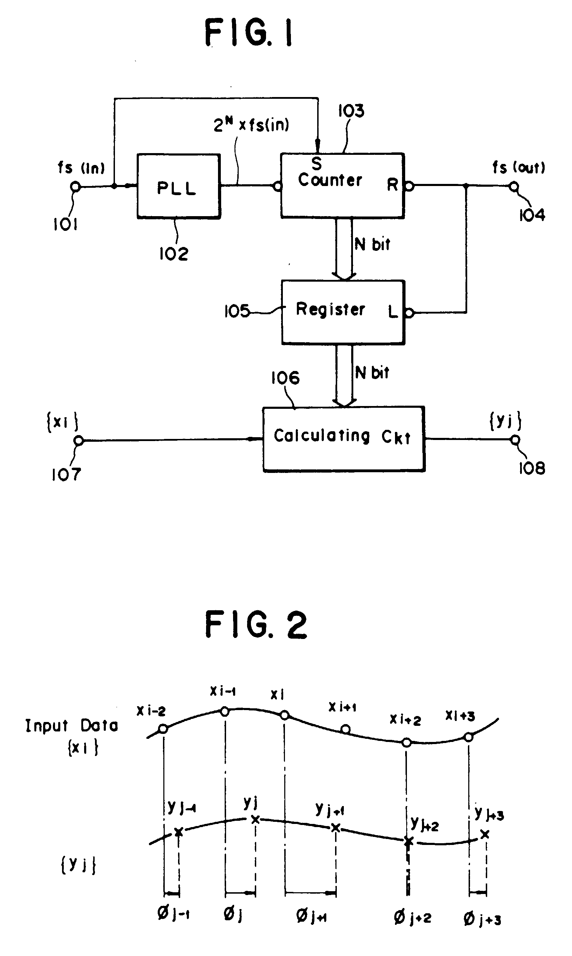

Digital converters by which an input PCM signal is converted to a digital signal of desired sampling frequency, without requiring an intermediate analog conversion step, are known. One example is shown in Figure 1 of the accompanying drawings, which shows a sampling frequency converter disclosed in Japanese Patent Applications Publication Nos. 57-115 015 and 61-204 700. The sampling frequency converter shown in Figure 1 is supplied with an input sampling clock signal Fs(in) having an input sampling frequency fs(in) and with an output sampling clock signal Fs(out) having an output sampling frequency fs(out). A sequence of input data samples $x_i$ with the input sampling frequency fs(in) is applied to an input terminal 107 and converted to a sequence of output data samples $Y_j$ having the output sampling frequency fs(out). A phase locked loop (PLL) 102 receives the input sampling clock signal supplied to a terminal 101 and multiplies the input sampling frequency fs(in) by a factor $2^N$ (where, for example, N = 7). As a result, the PLL 102 produces a high frequency clock signal of a frequency $2^N.fs(in)$. This high frequency clock signal is supplied to a counter 103 which is set in response to each pulse of the input sampling clock signal Fs(in) (applied to a set input S) and is reset in response to each pulse of the output sampling clock signal Fs(out). The output sampling clock signal is supplied to a reset input R of the counter 103 and also to a latch input L of a N-bit register 105. The output of the counter 103 is coupled to the register 105 and the count reached by the counter is transferred to and latched in the register upon the occurrence of an output sampling clock pulse.

As a result, the count reached by the counter 103 and latched in the register 105 is representative of the phase of the output sampling clock pulse with respect to the immediately preceding input sampling clock pulse. That is, the phase difference between the output sampling point and the immediately preceding input sampling point is represented by the N-bit count which is normalised to unity. This N-bit normalised phase difference is supplied to a calculating circuit 106.

The calculating circuit 106 functions to convert the input data samples $x_i$ to output data samples $y_j$ in response to each N-bit normalised phase difference supplied thereto by the register 105. The converted output data samples are obtained at an output terminal 108.

The relationship between the N-bit phase data stored in the register 105 and represented as phase data $\phi_j$, the input data samples $x_i$ and the output data samples $Y_j$ are graphically depicted in Figure 2 of the accompanying drawings. Of course, if the input data samples are converted to analog form, the resultant analog signal would, ideally, be identical to the analog representation of the output data sample $y_j$. The calculating circuit 106 functions to calculate the sample value of an output data sample $y_j$ at an output sampling point in response to an input data sample $x_i$ by using multinomial interpolation or digital filtering, as described below.

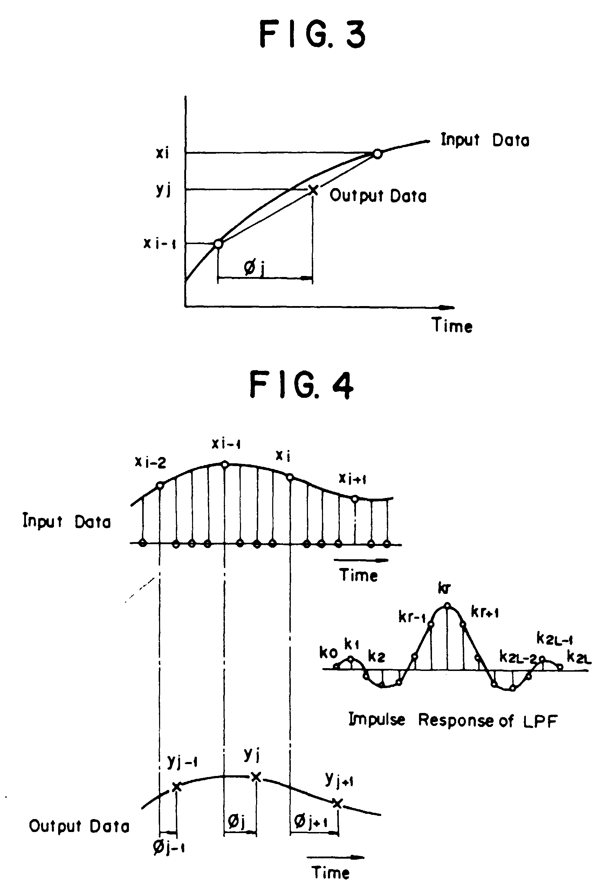

As an example, and with reference to Figure 3 of the accompanying drawings, a method of calculating an approximate value of an output data sample by multinomial interpolation is represented. Here, the multinomial interpolation is interpolation of the first degree, commonly referred to as linear interpolation. From Figure 3, it can be seen that samples $x_i$ and $x_{i-1}$ represent amplitudes of the input data samples, $y_j$ represents an amplitude of an output data sample,

and $\phi_j$ represents the phase of an output sample point relative to the immediately preceding input sample point ( $0 \leq \phi_j < 1$). The amplitude $y_j$ of the output sample point may be expressed as:

$$y_j = x_{i-1} + (x_i - x_{i-1}). \ \phi_j.$$

Thus, the output amplitude at a desired output sample point may be calculated from the data input amplitudes $x_i$ and $x_{i-1}$ and from the phase data $\phi_j$.

An example of digital filtering is represented by the waveforms shown in Figure 4 of the accompanying drawings. Here, the input-tooutput sampling frequency conversion ratio is assumed to be L/M, wherein L and M are integers. Sampling frequency conversion is carried out as follows:

First, L-1 zero-valued samples are filled in between adjacent samples of the input sampling sequence $x_i$. As a consequence of such processing, the apparent sampling frequency is increased by a factor L but the spectrum of the input sampling sequence remains unchanged. The sampling sequence with this increased sampling frequency then is convolved with (or multiplied by) a coefficient sequence $K_0$, $K_1$, $K_2$, ..., $K_r$, ..., $K_{2r-1}$, $K_{2r}$ which are samples of the impulse response of a low-pass filter having a pass band which passes the lower of the input sampling frequency fs (in) or the output sampling frequency fs(out) in a range of up to L/2 times the passed sampling frequency. As a result of this multiplication processing, interpolated sample data having a sampling rate which is L times that of the input sampling frequency is obtained.

The interpolated sample data $y_j'$, whose sampling rate is L times the input rate, may be represented as:

$$y_j = ... + x_{i-2}.K_{r+L-L}. \ \phi_j + x_{i-1}.K_{r-L}. \ \phi_j$$

$$+ x_i.K_{r-L-L}. \ \phi_j + x_{i+1}.K_{r-2L-L}. \ \phi_j$$

$$+ ...$$

$$[\phi_j = \phi/L, \ 1/L, \ 2/L, \ ..., \ (L-1/L)].$$

In order to calculate the amplitude of one output sample, the Lth coefficients may be extracted and summed in a summation of products process that may be carried out by a digital signal processor (DSP). Then, the amplitude of the L-th output sample may be reduced by a factor 1/M, to produce an output data sample $y_j$ whose sampling frequency is converted to L/M relative to the input sampling frequency. By performing the foregoing calculation for each output sample point once for each M input data samples, the number of calculations can be reduced by the factor 1/M.

Obtaining the output sampling sequence $y_j$ by the above-mentioned convolution calculation generally relies upon a high speed clock signal which is generated by increasing the input sampling frequency (or the output sampling frequency) many times. This multiple of the input data sampling frequency (or output data sampling frequency) is used to drive the digital signal processor.

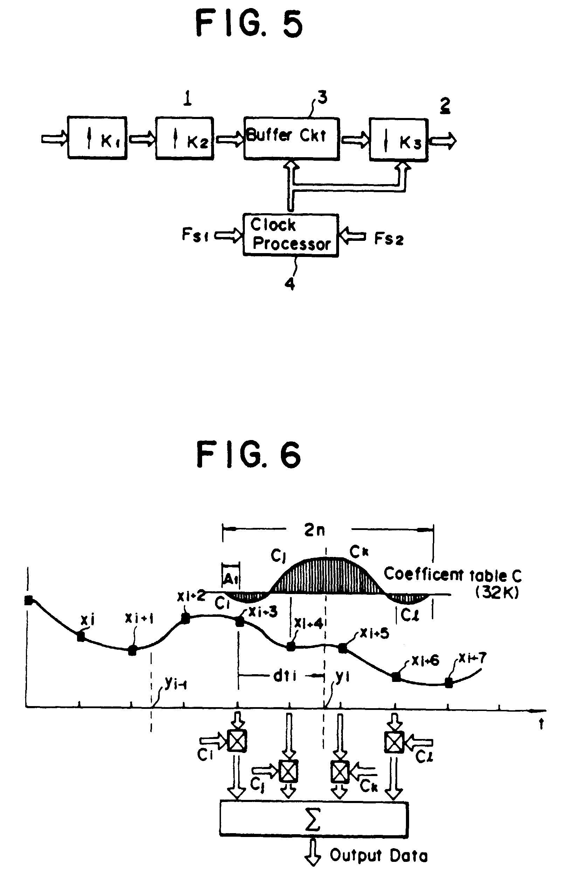

Another example of a previously proposed sampling frequency converter is illustrated in Figures 5 to 7 of the accompanying drawings. In this example, the input data sequence is over-sampled by a fixed ratio, for example by a factor of 4, and the oversampled input data sequence is supplied to a buffer circuit from which four data samples are read, each being multiplied by a coefficient related to the phase different between an input sampling clock signal Fs1 and an output sampling clock signal Fs2. The products are summed, thereby producing the desired output data sequence at the selected output sampling frequency, with the resultant output samples each exhibiting proper amplitude values.

As shown in Figure 5, input data having an input sampling rate fs1 is supplied to a two-stage fixed ratio over-sampling filter 1 and is converted into data whose sampling frequency is a multiple of the input sampling rate. A first stage of the over-sampling filter 1 operates to increase the input sampling frequency by a factor K1 and, thus, may be considered a K1-times over-sampling filter. Likewise, a second stage of the filter 1 functions to increase the sampling rate of the samples supplied thereto from the first stage by a factor K2 and may be considered a K2-times over-sampling filter. In a typical embodiment, K1 = K2 = 2, resulting in an increase in the input sample ratio by a factor of 4. The output of the over-sampling filter 1 is supplied to a buffer circuit or buffer 3. Within a period Ts1 of the input sampling clock signal Fs1, there are included four samples of the oversampled input data, and these four samples are read out from the buffer 3 during the period Ts1. The buffer write-in and read-out operations are controlled by an output of a clock processor 4.

The four samples read from the buffer 3 are multiplied by predetermined coefficients in a digital filter 2, the latter also being controlled by clock processor 4. As a result of this multiplication operation, output data samples having the desired sampling rate of Fs2 are obtained.

The instantaneous relative time different $dt_i$ between the input sampling clock signal Fs1 and the output sampling clock signal Fs2, that is between the input and output data samples, is detected by the clock processor 4. Based upon this relative time difference $dt_i$, the buffer 3 and digital filter 2 are controlled in the manner described below.

Figure 6 is a waveform diagram useful for understanding the operation of the digital filter 2. In Figure 6, the over-sampled input data samples are represented as samples $x_i$, $x_{i+1}$, ... having a sampling rate 4fs1; and output data samples $Y_{i-1}$, $Y_i$, ... exhibit the sampling rate of Fs2 and are produced at times relative to the oversampled samples $x_i$, $x_{i+1}$, etc. The amplitude of an output sample $y_i$ is obtained by multiplying four oversampled samples $x_{i+3}$, $x_{i+4}$, $x_{i+5}$ and $x_{i+6}$ by coefficients $c_i$, $c_j$, $c_k$ and $c_l$, respectively, and then adding all of these products together. The coefficients $c_i$, $c_j$, etc. are samples of the impulse response of a low pass filter, similar to that shown in Figure 4, represented by, for example, 32K samples. These coefficient samples are stored in a coefficient table C which is shifted so that its centre coincides with the time at which the output sample $y_i$ is produced. Then, the coefficients $c_i$, $c_j$, $c_k$ and $c_l$ are selected from the coefficient table C at the times that oversampled data samples $x_{i+3}$, $x_{i+4}$, etc. are read from the buffer 3.

The relative time difference dt between an input data sample, assumed to be the sample $x_{i+3}$, and an output sample $y_i$ (the precise position where an output sample amplitude is to be calculated) cannot be measured accurately due to clock jitter or the like. A time-related error in determining the position of the output sample causes an amplitude error in the sample amplitude calculation. This amplitude error must be kept below one quantising step. That is, the least significant bit in an output sample cannot be erroneous. Since the relative time difference dt cannot be measured, it must be calculated to an accuracy of virtually 16 bits.

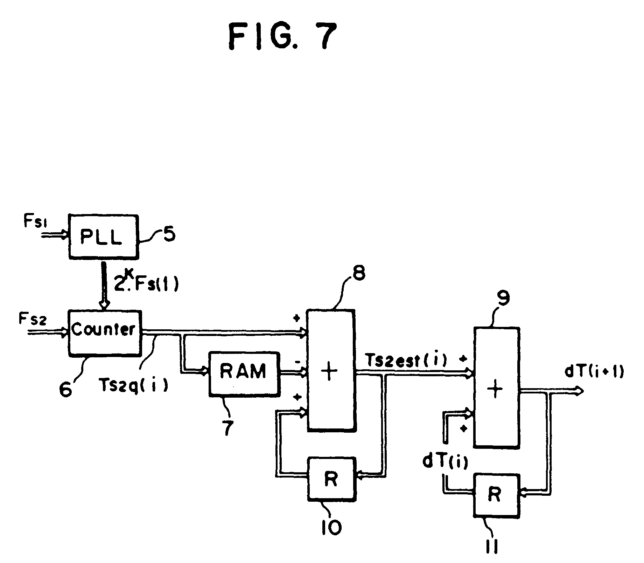

Figure 7 is a block diagram of an example of a previously proposed clock processor 4 used to provide an error-free updating of relative time difference dt(i) carried out by measuring and averaging the output sampling period Ts2 and accumulating relative time differences dt. The clock processor 4 of Figure 7 includes a phase locked loop (PLL) 5, a counter 6, a random access memory (RAM) 7, adders 8 and 9 and delay circuits 10 and 11. The PLL 5 generates a clock signal whose frequency is a multiple of the input sampling frequency fs1, that is, a clock frequency equal to $2^k fs1$. This clock signal is used to measure the period Ts2 of the output sampling frequency fs2. This measured period, which is designated Ts2q(i), is coarsely quantised with an accuracy of 6 to 7 bits. The measured output sampling period Ts2q(i) is averaged over a time period sufficiently long to increase its resolution to 16 bits (or more), and this averaged output sampling period is designated Ts2(est)(i). The average value Ts2(est)(i) must be measured such that no systematic down-rounding or up-rounding occurs over several samples, because values due to such up-rounding or down-rounding accumulate as errors. To obtain the average value of the clock period Ts2, a simple finite impulse response (FIR) averaging circuit, for example one with a z-Transform

$$H(z) = (1 - z^{-n})/(1 - z^{-1})$$

can be used. One advantage to such FIR averaging circuits is that they introduce no quantisation error. In Figure 7, the RAM 7, adder 8 and delay circuit 10 function as averaging circuitry, and the value Ts2(est)(i) is provided at the output of the adder 8.

When starting from an arbitrary or defined initial value dt(0), the relative time difference dt between input and output data samples is updated as

$$dt(i+1) = [dt(i) + Ts2(est)(i)] \, Mod(Ts1).$$

With numerical values normalised to a unit of Ts1 = 1, the modulo operation requires no additional hardware.

In the above-described previously proposed examples, calculation and control of the output data samples are carried out as a function of the relative time difference $dt_i$, and this relative time difference $dt_i$ is determined from the input sampling clock signal Fs1 and the output sampling clock signal Fs2. That is, once the time difference $dt_i$ is calculated, it is used to generate addresses for the filter coefficients which, in turn, are used to multiply the oversampled input data samples to calculate the output data samples. This technique suffers from several disadvantages. The overall calculating process is complex and time-consuming. Also, since the read/write operations of the buffer have been controlled as a function of the time difference $dt_i$ produced by the clock processor 4 (Figure 5), such read/write control has been complicated.

The document EP-A-137,323[STUDER] discloses a sampling frequency converter for converting sampled input data having an input sampling frequency into sampled output data having a selected output sampling frequency, whereby filter coefficients are controlled in accordance with the ratio of the time difference between two successive sampling times for the input and output samples.

According to one aspect of the present invention, the sampling frequency of the sampled input data is increased by an over-sampling circuit, and the oversampled data is temporarily stored and subsequently read at a rate determined by the ratio between periods of the input and output sampling frequencies. The input sampling frequency periods as well as the output sampling frequency periods each are averaged, and both averaged periods are used to generate filter coefficients which are supplied to a variable filter that produces converted data samples by processing the over-sampled data read from the buffer with the filter coefficients. Thus, converted data samples of the output sampling frequency are generated.

Other aspects of the present invention are set out in claims 1 and 5.

An embodiment of the invention described in detail below seeks to provide a sampling frequency conversion technique which overcomes or at least alleviates the above-noted drawbacks and disadvantages. The technique converts a signal sampling frequency without relying upon the time difference between input and output data samples. The technique generates addresses for selecting filter coefficients used for sampling frequency conversion in accordance with a relatively simple yet accurate implementation. The sampling frequency conversion operation suffers from minimal quantisation error.

The invention will now be further described, by way of illustrative and non-limiting example, with reference to the accompanying drawings, in which:

Figure 1 is a block diagram, described above, of a previously proposed sampling frequency converter;
Figures 2 to 4, described above, are diagrams useful for understanding the operation of the sampling frequency converter of Figure 1;
Figure 5, described above, is a block diagram of another previously proposed sampling frequency converter;
Figure 6, described above, is a diagram useful for understanding the operation of the sampling frequency converter of Figure 5;
Figure 7, described above, is a block diagram of a clock processor that can be used in the sampling frequency converter of Figure 5;
Figure 8 is a block diagram of a clock processor for a sampling frequency converter according to the invention of copending European Patent Application No. 88312325.9 (Publication No. EP-A-O 323 200), from which the present application was divided out;
Figure 9 is a block diagram of an embodiment of an overflow check circuit shown in Figure 8;
Figure 10 is a waveform diagram useful for understanding the operation of the circuit shown in Figure 9;
Figure 11 is a block diagram of another embodiment of the overflow check circuit shown in Figure 8;
Figure 12 is a waveform diagram useful for understanding the operation of the circuit shown in Figure 11;
Figure 13 is a block diagram of a sampling frequency converter embodying the invention of the present application;
Figure 14 is a waveform diagram useful for understanding the operation of the converter shown in Figure 13;
Figure 15 is a block diagram of an event detector shown in Figure 13;
Figure 16 is a diagram useful for understanding the operation of the event detector shown in Figure 15;
Figure 17 is a block diagram of an embodiment of an averaging circuit shown in Figure 13; and
Figure 18 is a diagram useful for understanding the operation of the averaging circuit shown in Figure 17.

The invention is defined by the appended claims.

Reverting to Figure 6, the first coefficient $c_i$ of the four coefficients $c_i$, $c_j$, $c_k$ and $c_l$ is stored at an address A1 of the coefficient table C. The address A1 is related to the relative time difference dt(i) between the input data sample $x_{i+3}$ and the time of occurrence of the output data sample $y_i$ as follows:

$$A1 + dt(i) = 0.5 \times Ts1$$

$$A1 = 0.5Ts1 - dt(i).$$

It will be recognised that the address A1 is a positive quantity and always is less than 0.25. Accordingly, a more general formula for the address A1 is:

$$A1 = (Ts1 - dt(i)) \bmod Ts1.$$

A1 is the complement of dt(i) Mod Ts1; and the calculation of dt(i), as was done in the above-described prior proposal, can be replaced by direct calculation of the address A1. The other addresses of the coefficient table, sometimes referred to herein as filter addresses, are:

$$A2 = (A1 + 0.25) \text{ Mod Ts1}$$

$$A3 = (A2 + 0.25) \text{ Mod Ts1}$$

$$A4 = (A3 + 0.25) \text{ Mod Ts1}.$$

In the foregoing equations, since A1 is less than 0.25, the modulo operation is not actually needed.

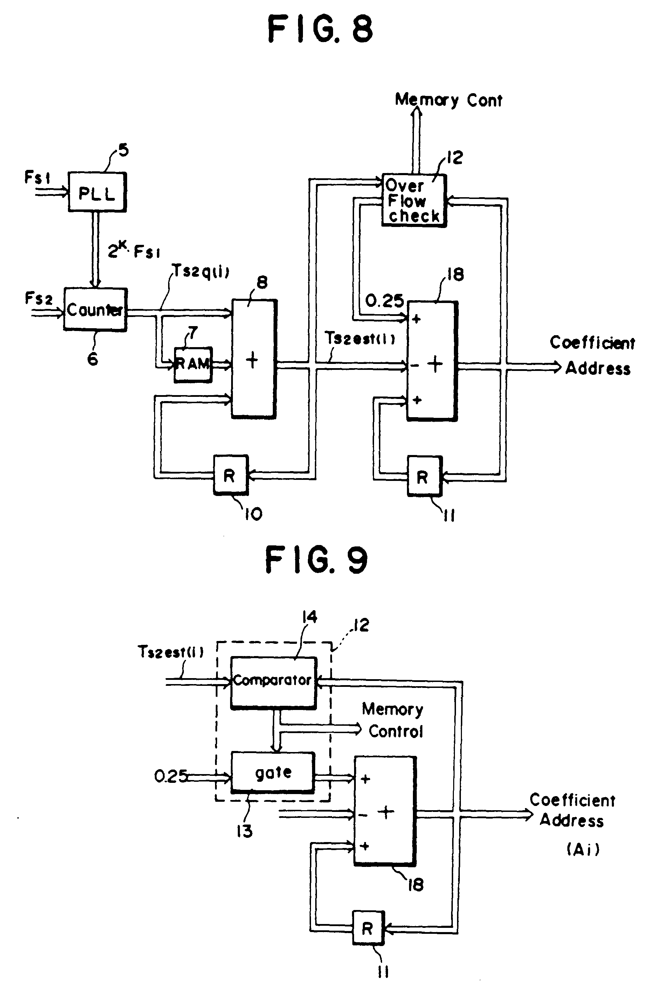

An embodiment of the invention of the above-cited European patent application from which the present application was divided out uses a clock processor shown in Figure 8 which differs from the previously proposed clock processor shown in Figure 7 in that the coefficient address as well as the buffer control are obtained directly from the averaged output sampling period Ts2(est)(i), produced at the output of the adder 8. Whereas the previous proposal used the averaged output sampling period Ts2(est)(i) to calculate the relative time difference dt(i) which then was used to generate addresses Ai, the present arrangement avoids the complex and time-consuming steps needed in the calculation of dt(i).

Those elements shown in Figure 8 which are the same as those described above with reference to Figure 7 are identified by the same references. The description of these elements is not repeated. From Figure 8, it can be seen that the output of the adder 8 is coupled to an adder 18 which calculates the coefficient address used to read out the appropriate filter coefficient which, in turn, is used to multiply the input data sample to effect a sampling frequency conversion. The coefficient address is fed back to the adder 18 by way of a delay circuit 11. The adder output also is supplied to an overflow check circuit 12 which selectively couples a fixed value to the adder 18 for summation with the other inputs supplied to the adder 18, depending upon the presence or absence of a detected overflow.

It will be appreciated that a sampling frequency conversion operation may increase the input sampling frequency, referred to herein as an "up convert", or may decrease the input sampling frequency, referred to as a "down convert". An embodiment of the overflow check circuit 12 for carrying out an up convert will be described first.

Let it be assumed that the output sampling period Ts2 is 0.9 times the input sampling period. That is, the sampling frequency is increased by a factor 10/9. Referring to Figure 9, the overflow check circuit 12 used to carry out an up convert includes a comparator 14 which compares the coefficient address A1 produced by the adder 18 with the averaged output sampling period Ts2(est)(i) generated by the adder 8 (Figure 8). When the coefficient address Ai is less than the averaged output sampling period Ts2(est)(i), the constant value 0.25 is added to the coefficient address so as to generate the next coefficient address. Conversely, when the coefficient address Ai is greater than the averaged output sampling period Ts2(est)(i), the constant value 0.25 is not added to the coefficient address. Thus, depending upon the output of the comparator 14, the constant numerical value 0.25 is selectively supplied to the adder 18 through a gate circuit 13 having an enable input coupled to the comparator.

The delay circuit 11 imparts a time delay of one period of the increased input sampling frequency, corresponding to one period of each sample that has been oversampled by the factor $2^k = 4$. When the input and output sampling frequencies are relatively close to each other, as in the example assumed herein, the coefficient addresses A1, A2 and A3 will not be larger than the averaged output sampling period Ts2(est)(i), but the coefficient address A4 possibly may be larger than the averaged output sampling period Ts2(est)(i). At the time that the coefficient address A4 is obtained at the output of the adder 18, the averaged output sampling period Ts2(est)(i) is supplied to the adder to be subtracted from the other values then supplied thereto. The averaged output sampling period Ts2(est)(i) is not supplied to the adder 18 at the time that the addresses A1, A2 and A3 are generated.

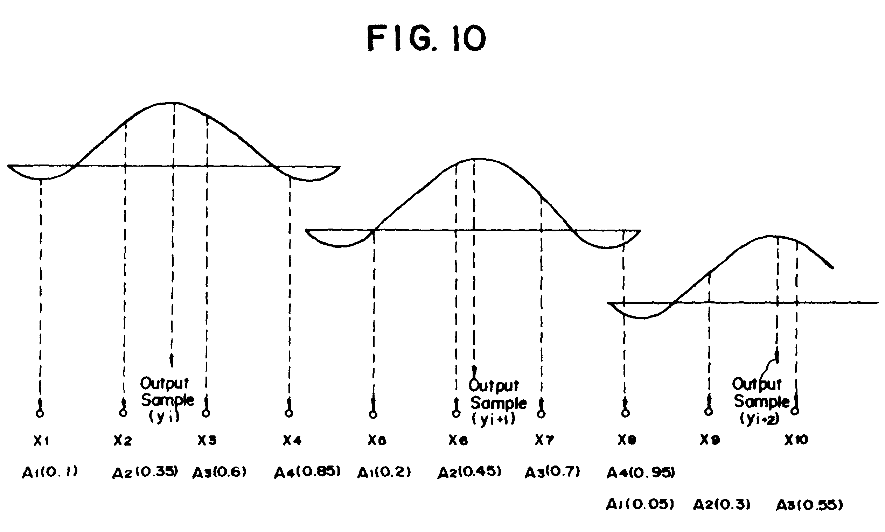

To facilitate an understanding of the operation of Figure 9, the operation will now be described with reference to specific examples of numerical values. These values are normalised, that is the input sampling period Ts1 is normalised to unity, resulting in the averaged output sampling period Ts2(est)(i) becoming approximately 0.9. Referring to Figure 10, input data samples $x_1$, $x_2$, ... represent the oversampled input data samples and the output data samples are represented as $y_i$, $y_{i+1}$, $y_{i+2}$, etc. The amplitudes of these three consecutive output data samples are to be calculated to effect proper frequency conversion. The relative times of occurrences of the output data samples and the oversampled input data samples are as illustrated. Furthermore, the low pass filter impulse response of the period Ts1 is seen to be shifted so as to be centred at each output data sample. The amplitude of the impulse response at the time of occurrence of each oversampled input data sample is the filter coefficient with which that input data sample is multiplied. Closely spaced samples of the impulse response amplitude are stored in an addressable memory; and the address used to read out a respective sample is generated by the adder 18.

In calculating the amplitude of the output data sample $y_i$, the address of the coefficient to be multiplied by the oversampled input data sample $x_i$ is assumed to be 0.1. Then, the addresses of the coefficients to be multiplied by the subsequent oversampled input data samples $x_2$, $x_3$ and $x_4$ become:

$$A2 = A1 + 0.25 = 0.35$$

$$A3 = A2 + 0.25 = 0.6$$

$$A4 = A3 + 0.25 = 0.85$$

In this case, each of the coefficient addresses A1 to A4 is less than the averaged output sampling period Ts2(est)(i), which has been defined as 0.9. Hence, the comparator 14 determines that each of these addresses Ai is smaller than the averaged output sampling period Ts2(est)(i) and this activates gate 13. As a result, the coefficient address A4 and the constant value 0.25 are supplied as positive values to the adder 18, while the averaged output sampling period Ts2(est)(i) is supplied as a negative value to the adder. Hence, the address A1 of the first coefficient for calculating the next output data sample $y_{i+1}$, that is the address A1 of the coefficient to be multiplied by the next oversampled input data sample $x_5$, becomes:

$$A1 = A4 + 0.25 - Ts2(est)(i)$$

$$= 0.85 + 0.25 - 0.9 = 0.2.$$

In the manner discussed above, the addresses A2, A3 and A4 of the coefficients to be multiplied by the subsequent oversampled input data samples $x_6$, $x_7$ and $x_8$ become:

$$A2 = A1 + 0.25 = 0.45$$

$$A3 = A2 + 0.25 = 0.7$$

$$A4 = A3 + 0.25 = 0.95.$$

Now, the address A4 of the coefficient to be multiplied by the oversampled input data sample $x_8$ has been calculated as 0.95 and is larger than the averaged output sampling period Ts2(est)(i) which has been assumed to be 0.9. Hence, the comparator 14 functions to disable the gate 13. As a consequence, in calculating the address A1 of the next coefficient which will be used to calculate the next output sample $y_{i+2}$, the value 0.25 is not added to the previous coefficient address A4. Rather, only the averaged output sampling period Ts2(est)(i) is subtracted from the coefficient address A4. As can be seen from Figure 10, the oversampled input data sample to be multiplied by the coefficient stored at the address A1 is not the next sample $x_9$ but, rather, the input data sample $x_8$ is used once again. Thus, the address A1 of the coefficient to be multiplied by the oversampled input data sample $x_8$ for calculating the output sample $y_{i+2}$ becomes:

$$A1 = A4 - Ts2(est)(i)$$

$$= 0.95 - 0.9 = 0.05.$$

As will be understood from the example just described, the output of the comparator 14 indicates whether an oversampled input data sample is to be used again and, thus, the comparator output is used to control the read/write operation of the buffer 3 shown in Figure 5.

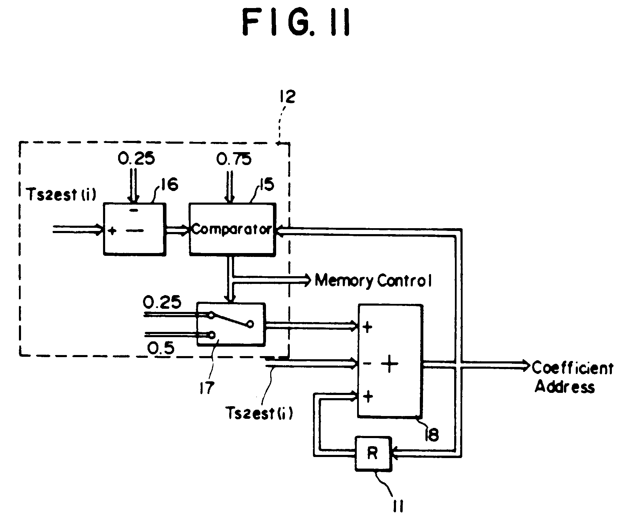

Next, an embodiment of the overflow check circuit 12 will be described for the arrangement wherein a down convert of the sampling frequency is to be carried out. For example, let it be assumed that the output sampling period Ts2 is increased to be equal to 1.1 times the input sampling period Ts1. That is, the sampling frequency is reduced by a factor 10/11. To carry out this down convert, the overflow check circuit 12 is configured as shown in Figure 11. Here, a subtracter 16 functions to subtract the fixed constant value 0.25 from the averaged output sampling period Ts2(est)(i) to obtain a value which, along with a constant value 0.75, is compared in a comparator 15 to the coefficient address Ai produced by the adder 18. The comparator 15 is coupled to a selector 17 to control the operation of the selector for supplying to the adder 18 either a constant value of 0.25 or a constant value of 0.5. More particularly, the selector 17 responds to the output of the comparator 15 to select the constant value 0.5 when the coefficient address Ai complies with the relationship:

$$0.75 < Ai < Ts2 \ (est)(i) - 0.25.$$

The selector 17 also responds to the output of the comparator 15 to supply to the adder 18 the constant value 0.25 when the coefficient address Ai is determined to comply with the relationships:

$$Ai \leq 0.75 \text{ or } Ai \geq Ts2(est)(i) - 0.25.$$

The constant value selected by the selector 17 is added to the coefficient address Ai by the adder 18.

As described above, the coefficient addresses A1, A2 and A3 each exhibit a value less than 0.75. Hence, when the adder 18 generates the coefficient address A1 or A2 or A3, the selector 17 selects the constant value 0.25 to be added to the preceding coefficient address which is fed back to the adder 18 by the delay circuit 11.

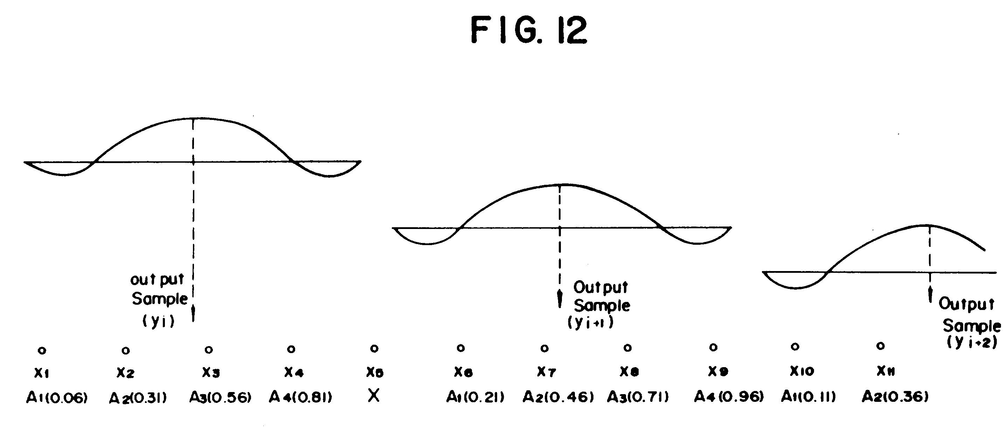

An understanding of the operation of the overflow check circuit shown in Figure 11 will be facilitated by reference to specific numerical values. Figure 12 illustrates waveforms similar to those shown in Figure 10 and juxtaposes those waveforms with respect to oversampled input data samples $x_1$, $x_2$, etc. As was described previously with reference to Figure 10, the illustrated impulse response characteristic is centred with respect to the time at which each output sample is to be produced.

Let is be assumed initially that the address of the first coefficient to be multiplied by the input data sample $x_i$ for producing the output data sample $y_i$ is 0.06. Then, the respective addresses of the coefficients to be multiplied by the subsequent oversampled input data samples $x_2$, $x_3$ and $x_4$ become:

$$A2 = A1 + 0.25 = 0.31$$

$$A3 = A2 + 0.25 = 0.56$$

$$A4 = A3 + 0.25 = 0.81.$$

Since the averaged output sampling period Ts2(est)(i) is assumed to be 1.1, as described above, the output of the subtracter 16 is Ts2(est)(i) - 0.25 = 0.85. Thus, the coefficient address A4 falls within the range 0.75 < A4 < 0.85 and the comparator 15 controls the selector 17 to select the constant value 0.5. Hence, the address A1 of the coefficient to be multiplied by the next oversampled input data sample for calculating the output data sample $y_{i+1}$ becomes:

$$A1 = A4 + 0.5 - Ts2(est)(i)$$

$$= 0.81 + 0.5 - 1.1$$

$$= 0.21.$$

As is apparent from Figure 12, the input data sample to be multiplied by the coefficient at the address $A_1$ is not $x_5$, which is the next sample and would be present at a time that the coefficient address would be A4 + 0.25 = 1.06. Rather, the sample $x_5$ is skipped. Hence, the next sample $x_6$ is multiplied by the coefficient at the address A1 = 0.21.

The addresses A2, A3, A4 of the coefficients to be multiplied by the subsequent oversampled input data samples $x_7$, $x_8$, $x_9$ are:

$$A2 = A1 + 0.25 = 0.46$$

$$A3 = A2 + 0.25 = 0.71$$

$$A4 = A3 + 0.25 = 0.96.$$

Here, the coefficient address A4 complies with the relationship:

$$A4 > Ts2(est)(i) - 0.25$$

and therefore the comparator 15 now controls the selector 17 to select the constant value 0.25. Thus, the address A1 of the coefficient to be multiplied by the next oversampled input data sample for calculating the next output data sample $y_{i+2}$ becomes

$$A1 = A4 + 0.25 - Ts2(est)(i)$$

$$= 0.96 + 0.25 - 1.1$$

$$= 0.11.$$

From Figure 12, it can be seen that the next oversampled input data sample to be multiplied by the coefficient stored at the address A1 is the sample $x_{10}$.

As will be understood from the foregoing description, the output of the comparator 15 determines whether an oversampled input data sample is to be skipped. Hence, the comparator 15, like the comparator 14 of Figure 9, is used for controlling the read/write operations of the buffer 3 (Figure 5).

The above-described arrangement of Figures 8 to 12 calculates the averaged output sampling period Ts2(est)(i) by using a high speed clock signal produced by increasing the input data sampling frequency fs1 (or, alternatively, the output data sampling frequency fs2) many times over, that is by a factor $2^k$. As a result, the sampling frequency converter of this embodiment employs a PLL operating at a high speed for generating that clock signal, and the PLL requires a sufficiently wide capture range to follow variations in frequency of the sampling clock signal Fs1 or Fs2 which it multiplies. Further, it may be difficult to synchronise the DSP which calculates the approximate values of the output data samples because the DSP operates in response to the high speed clock signal generated by the PLL. Additionally in the above-described arrangement, the averaging process for determining the averaged output sampling period Ts2 (est)(i) to improve accuracy in the sampling rate conversion is carried out in a so-called open-loop calculation or averaging method based on the z-Transform

$$H(z) = (1 - z^{-n}) / (1 - z^{-1})$$

$$= 1 + z^{-1} + z^{-2} + ... + z^{-n+1}.$$

Using this averaging method, if a step form phase error occurs, a control error is produced.

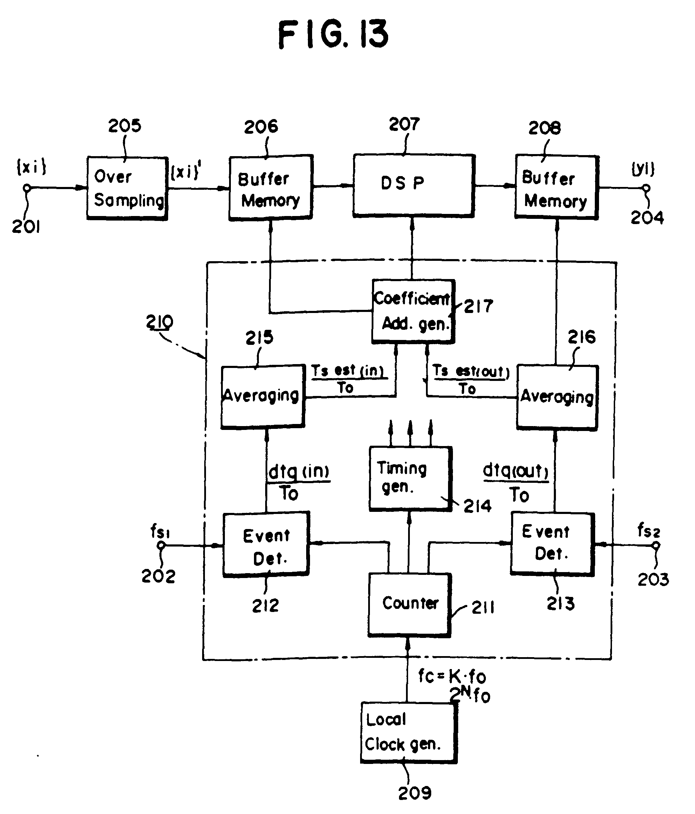

The above-noted difficulties encountered in the arrangement just described can be overcome by an embodiment of the present invention shown in block diagram form in Figure 13.

As illustrated, a signal input terminal 201 is supplied with the input data samples $(x_i)$ to be converted, and a clock signal input terminal 202 is supplied with an input sampling clock signal Fs1 of the input data sampling frequency fs1. A clock signal input terminal 203 is supplied with an output sampling clock signal Fs2 having the sampling frequency fs2 of the output data samples $(y_j)$ which are produced at a signal output terminal 204.

The sampling frequency converter comprises an oversampling circuit 205 for oversampling the input data samples $(x_i)$ supplied to the signal input terminal 201 to produce oversampled input data samples having a sampling frequency $2^M$ times the input sampling frequency fs1 (as an example, M = 2). A buffer memory 206 is coupled to the oversampling circuit 205 for temporarily storing sample values $[x_i]'$ of the oversampled input data samples having the sampling frequency 4.fs1. A digital signal processor (DSP) 207 is coupled to the buffer 206 for subjecting the oversampled sequence $[x_i]'$ read out from the buffer to a digital filtering process using filter coefficients which are samples of the impulse response of a low-pass filter capable of passing the increased sampling frequency 4.fs1 to thereby calculate an interpolated amplitude value at a sample point of the output data sample $(y_j)$ whose sampling frequency thus has been converted to the output sampling frequency fs2. Another buffer memory 208 is coupled to the DSP 207 for temporarily storing each of the interpolated amplitude values of the output data samples ($y_j$). A local clock generator 209 generated a local clock signal Fc (having a local clock frequency fc) to provide a source of timing signals for the buffer memories 206, 208 and the DSP 207. A conversion controller 210 controls the operations of the buffer memories 206, 208 and the DSP 207 in response to the sampling frequencies fs1, fs2 derived from the sampling clock signals Fs1, Fs2 supplied to the clock signal input terminal 202, 203 and to the local clock frequency fc derived from the local clock signal Fc.

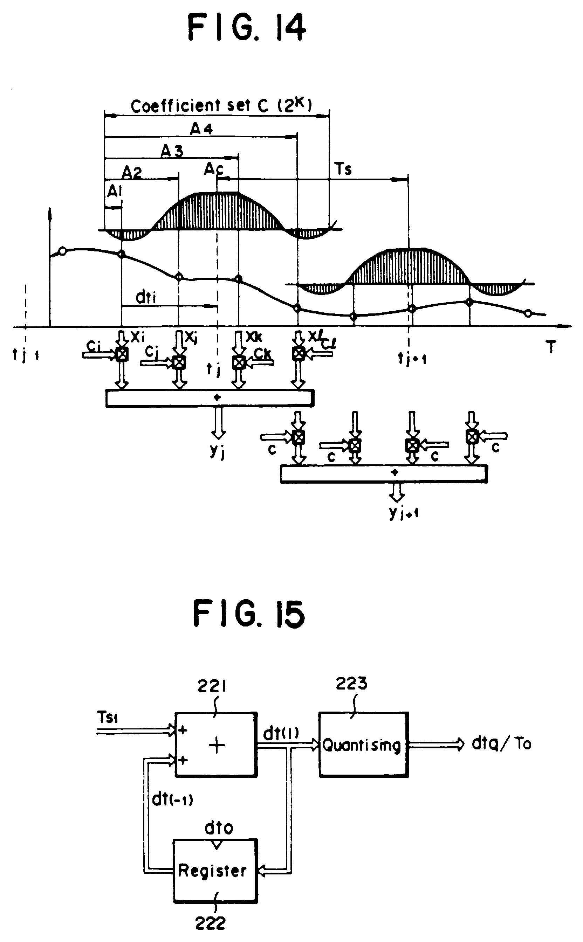

The DSP 207 reads out filter coefficients (of the type described above) from a coefficient memory (not shown) according to coefficient addresses supplied by a coefficient address generator 217 of the conversion controller 210 and performs a multiply-and-add operation with these filter coefficients. For example, the DSP 207, in response to the oversampled sequence $[x_i]'$ read from the buffer memory 206, reads out four filter coefficients $c_i$, $c_j$, $c_k$ and $c_l$ which coincide in time to the sample points of samples $x_i$, $x_j$, $x_k$ and $x_l$, respectively, as schematically shown in Figure 14. These coefficients are included in a set of $2^k$ filter coefficients which constitute the impulse response characteristic of a low-pass filter to the sampling frequency 4.fs1. This set of coefficients is stored in, for example, a table, with the centre address Ac of the coefficient filter set to be maintained coincident with a sample point $t_j$ of the output data sample sequence $[y_j]$. The four samples $x_i$, $x_j$, $x_k$, $x_l$ read from the buffer 206 are multiplied by the filter coefficients $c_i$, $c_j$, $c_k$, $c_l$, respectively, and the products are summed, thereby calculating the interpolated output sample value $y_j$ at the sample point $t_j$.

The local clock generator 209 includes a quartz oscillator or the like oscillating at the local clock frequency fc. Preferably, fc = K.fo, where the factor K represents an integer that is a power of 2, such as $2^N$, and the frequency fo represents a frequency higher than the input sampling frequency fs2. The sampling frequencies fs1, fs2 are generally close to 48kHz or below, and the frequency fo also is selected to be close to 48kHz. The local clock frequency fc is of a frequency for which the DSP electronic circuitry (e.g. a DSP chip) constituting the DSP 207 is designed and, at this frequency, the digital filtering process in the DSP is performed such that the quantisation error of the output data samples ($y_j$) is kept below one quantising step.

The conversion controller 210 comprises a modulo-K counter 211 for counting the pulses of the local clock signal Fc supplied from the local clock generator 209 and event detectors 212, 213 for measuring the relative time differences $dt_{q1}/To$, $dt_{q2}/To$ between the clock period To (To = 1/fo) and each of the sampling periods (Ts1 = 1fs1 and Ts2 = 1/fs2) as a function of the count output of the modulo-K counter 211. A timing generator 214 is included in the controller 210 for generating various timing signals in response to the modulo-K count output; and first and second averaging circuits 215, 216 are used in the controller for calculating estimated sampling periods $Rs_{est}1/To$, $Ts_{est}2/To$ of the input and output sampling clock signals Fs1, Fs2, respectively, based upon the relative time differences $dt_{q1}/To$, $dt_{q2}/To$ measured by the event detectors 212, 213. The conversion controller 210 also includes the above-mentioned coefficient address generator 217 for calculating the coefficient addresses in response to the estimated sampling periods $Ts_{est}1/To$, $Ts_{est}2/To$ obtained by the averaging circuits 215, 216, for selecting the approximate filter coefficients with which to multiply the samples read from the buffer memory 206.

The event detectors 212, 213 measure the relative time differences $dt_{q1}$, $dt_{q2}$ between each of the sampling periods Ts1, Ts2 and the clock period To, but such time differences cannot be measured in real time with high accuracy due to clock jitter or the like. Hence, in the present embodiment, clock edges or synchronisation patterns for the sampling clock signals Fs1 and Fs2 are detected during every clock period To, it being recognised that To is shorter than either of the sampling periods Ts1 and Ts2. The calculating process for measuring the relative time differences $dt_{q1}$, $dt_{q2}$ uses clock signal pulses of period Tc (where Tc = 1/fc) which are counted by the modulo-K counter 211.

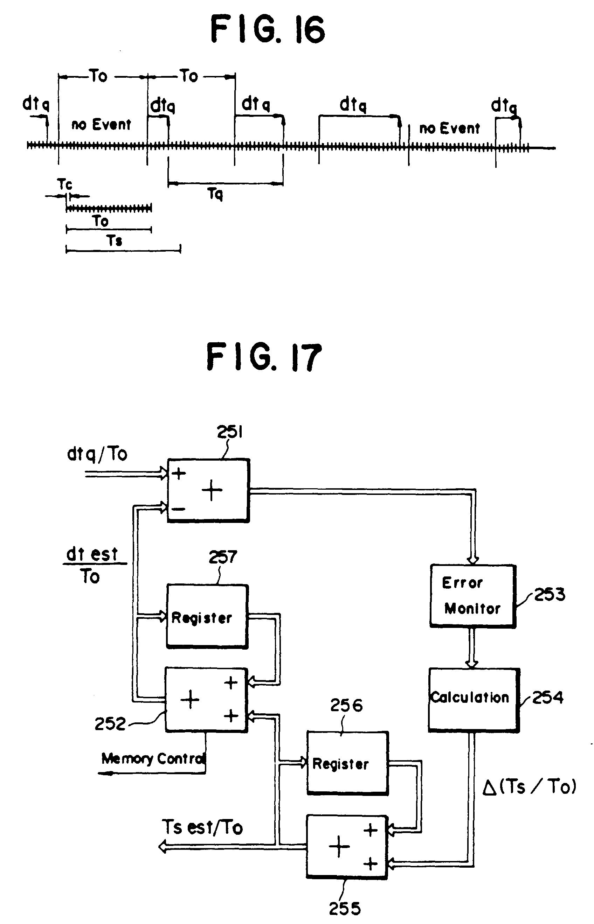

A functional representation of the event detector 212 is shown in the block diagram of Figure 15. This block diagram also is representative of the event detector 213. For convenience, the following description relates to the event detector 212. An adder 221 supplied with information representing the input sampling period Ts1 adds this input sampling period information to the information representing the relative time difference $dt_{(-1)}$ of the preceding input sampling period Ts1 temporarily stored in a register 222. The output of the adder 221 is thus indicative of the relative time difference dt between the input sampling period Ts1 and the clock period To. This relative time difference information dt is fed back for storage in the register 222 and also is supplied to a quantising circuit 223. The quantising circuit 223, as shown in Figure 16, measures the relative time difference information (dt) as a function of the number of pulses of the local clock signal Fc counted during this time difference interval, that is in units of the local clock signal period Tc, and calculates a measured relative time difference $dt_q/To$ which represents the ratio of the relative time difference dt to the clock period To.

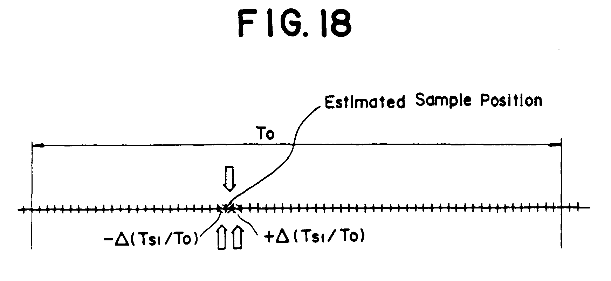

The averaging circuits 215, 216, supplied with signals representing the measured relative time differences $dt_q1/To$ and $dt_q2/To$ obtained from the event detectors 212 and 213, respectively, estimate the input and output sampling periods $Ts_{est}1/To$ and $Ts_{est}2/To$. These estimated sampling periods represent the ratio of the input sampling period Ts1 to the clock period To and the ratio of the output sampling period Ts2 to the clock period To. Referring to the block diagram of Figure 17, the averaging circuit 215 includes an adder 251 which is supplied with a representation of the measured relative time difference $dt_q/To$ between the input sampling period and the clock period To and subtracts therefrom information representing an estimated relative time difference $dt_{est}/To$ supplied thereto from an adder 252. The adder 251 calculates an error between the measured time difference $dt_q/To$ and the estimated relative time difference $dt_{est}/To$. This error is monitored in an error monitor 253 coupled to the adder 251. Correcting information $\Delta(Ts/To)$ for the next estimated input sample position, as shown in Figure 18, is produced by a calculating circuit 254 based on the monitored error information, and this correcting information is supplied to a further adder 255.

The adder 255 adds the correcting information $\Delta(Ts1/To)$ to information representing the previous estimated input sampling period $(Ts_{est}1/To)_{(-1)}$ fed back through a register 256 and thereby calculates an estimated input sampling period $Ts_{est}1/To$. This estimated input sampling period is supplied to the adder 252. At this point it should be noted that the register 256 is supplied at the start with information of an initial value $Ts_{q0}$ of the estimated input sampling period from the adder 255.

In the averaging circuit 215, the adder 252 adds information representing the estimated input sampling period $Ts_{est}1/To$ to information representing the previous estimated input sampling period $(Ts_{est}1/To)_{(-1)}$ fed back through a register 257 and thereby calculates the estimated relative time difference $dt_{est}/To$. This calculated information is supplied to the adder 251. The register 257 is supplied at the start with an initial value $dt_{q0}$ of the estimated relative time difference from the adder 252.

Information on the initial values $Ts_{q0}$ and $dt_{q0}$ supplied to the registers 256 and 257 are obtained by direct quantised measurement of, for example, the relative time difference $dt_q$.

By supplying information on the estimated input sampling period $Ts_{est}1/To$ to the adder 252 which calculates the estimated relative time difference $dt_{est}/To$ and by calculating an error between the measured relative time difference $dt_q/To$ and the estimated relative time difference $dt_{est}/To$, and furthermore by feeding back correcting information $\Delta(Tsl/To)$ to correct the estimated input sampling period $Ts_{est}1/To$, highly accurate information representing the estimated input sampling period $Ts_{est}/To$ is obtained by direct quantised measurement of the relative time difference $dt_q$ through adaptive estimation without using a filter per se. Further, by updating information on the estimated relative time difference $dt_{est}/To$ with an accurate estimated input sampling period $Ts_{est}/To$, the estimated relative time difference falls within the observed range of the measured relative time difference $dt_q$ for long durations. Correction of the estimated input sampling period with the correcting information $\Delta(Tsl/To)$ avoids excessive changes to the estimated input sampling period $Ts_{est}/To$ and, thus, phase inversion and distortion are not produced.

While Figure 17 is illustrative of a functional block diagram of the averaging circuit 215, Figure 17 also is representative of the averaging circuit 216. Therefore, the foregoing description is applicable to the averaging circuit 216.

The event detector 212 (as an example) detects where the measured relative time difference $dt_{est}$ occurs compared to the estimated relative time difference $dt_q$. The history of this event is useful in calculating suitable corrections to the estimated input sampling period $Ts_{est}/To$. If, for example, it took 500 samples for the estimated input relative time difference $dt_{est}$ with a constant estimated input sampling period $Ts_{est}1$ to change from a value below the measured relative time difference $dt_q$ range to a value above that range, then the current error in the estimated input sampling period $TS_{est}1$ is estimated as 1/500 of the quantisation step for the measured relative time difference $dt_q$.

More complex cases based on monitoring the change in the estimated input sampling period $Ts_{est}1$ can of course be handled by more complex algorithms.

The coefficient address generator 217 is supplied with information representing the estimated input sampling period $Ts_{est}1/To$ provided by the averaging circuit 215 with information representing the estimated output sampling period $Ts_{est}2/To$ provided by the averaging circuit 216 to generate from the ratio of the estimated output sampling period to the estimated input sampling period the coefficient addresses for reading out the filter coefficients $c_i$, $c_j$, $c_k$, $c_l$ for use by the DSP 207 for interpolation processing.

For an embodiment of the coefficient address generator 217, reference may be made to Figures 8, 9 and 11.

## Claims

1. A sampling frequency converter for converting sampled input data having an input sampling frequency into sampled output data having a selected output sampling frequency, the converter comprising:

   over-sampling means (205) connected to be supplied with said sampled input data for increasing the sampling frequency of said sampled input data by a factor $2^k$, to provide oversampled data;
   buffer memory means (206) connected to be supplied with said oversampled data for temporarily storing same and for reading out the stored oversampled data at a read-out rate determined by a ratio between periods of said input sampling frequency and said output sampling frequency;
   averaging means (209, 212, 213, 215, 216) for averaging the periods of said input sampling frequency and for averaging the periods of said output sampling frequency for a predetermined time duration;
   filter coefficient generating means (217) responsive to said averaged periods of said input sampling frequency and to said averaged periods of said output sampling frequency for generating data representing a set of predetermined filter coefficients derived from a low pass filter impulse response;

variable filter means (207) for receiving the oversampled data read out from said buffer memory means (206) and the filter coefficient data generated by said filter coefficient generating means for producing converted data samples; and

output means (208) for supplying the converted data samples at said output sampling frequency.

2. A converter according to claim 1, comprising buffer control means (210) for generating buffer control signals to be supplied to said buffer memory means (206) to control the read out of oversampled data from said buffer memory means.

3. A converter according to claim 1, wherein said averaging means comprises local clock generating means (209) for generating a local clock signal, first means (212) for determining a relative ratio between the period of said input sampling frequency and the period of said local clock signal, second means (213) for determining a relative ratio between the period of said output sampling frequency and the period of said local clock signal, and first and second averaging means (215, 216) for averaging each of said ratios.

4. A sampling frequency converter according to claim 3, wherein said first averaging means (215) includes a first adder (251) connected to be supplied with a measured relative time difference between an input sampling period and said local clock period and with an estimated relative time difference therebetween such that said adder (251) is operative to determine an error between the measured and estimated relative time differences, error monitor means (253) connected to be supplied with the error determined by said first adder (251) for producing a correction output, a second adder (255) connected to be supplied with the correction output of said error monitor means (253) and a previous estimate of the input sampling period produced by said second adder (255) for generating a corrected estimate of the input sampling period, and a third adder (252) connected to be supplied with the corrected estimate of the input sampling period generated by said second adder (255) and a previous corrected estimate for generating said estimated relative time difference between said input sampling period and local clock period and supplying same to said first adder (251).

5. A method of converting sampled input data having an input sampling frequency into sampled output data having a selected output sampling frequency, the method comprising the steps of:

over-sampling (205) the sampled input data to increase the sampling frequency thereof by a factor $2^k$, to provide oversampled data;

temporarily storing (206) the oversampled data and reading out the stored oversampled data at a read-out rate determined by a ratio between the period of said input sampling frequency and the period of said output sampling frequency;

averaging (209, 212, 213, 215, 216) the periods of said input sampling frequency and the periods of said output sampling frequency for a predetermined time duration;

generating (217) predetermined filter coefficients derived from a low pass filter impulse response in response to the averaged periods of said input sampling frequency and the averaged periods of said output sampling frequency;

variably filtering (207) the read out oversampled data by processing same with the filter coefficients for producing converted data samples; and

supplying (208) the converted data samples at said output sampling frequency.

6. A method according to claim 5, wherein the step of averaging comprising generating (209) a local clock signal, determining (212) a relative ratio between the period of said input sampling frequency and the period of said local clock signal, determining (213) a relative ratio between the period of said output sampling frequency and the period of said local clock signal, and averaging (215, 216) each of said ratios.

7. A method according to claim 6, wherein the step of averaging the relative ratio between the input sampling period and the local clock period comprises adding (251) a measured relative time difference between the input sampling period and the local clock period and an estimated relative time difference therebetween to detect an error between the measured and estimated relative time differences, producing (253) a correction output in response to the detected error, adding (255) the correction output and a previous estimate of the input sampling period for generating a corrected estimate of the input sampling period, and adding (252) the corrected estimate of the input sampling period and a previous corrected estimate for producing said estimated relative time difference between said input sampling period and said local clock period; and wherein the corrected estimate of the input sampling period is the averaged relative ratio between the input sampling period and the local clock period.

**Patentansprüche**

1. Abtastfrequenzumsetzer für die Umsetzung von abgetasteten Eingangsdaten mit einer Eingangsabtastfrequenz in abgetastete Ausgangsdaten mit einer ausgewählten Ausgangsabtastfrequenz, wobei der Umsetzer aufweist:

   eine mit den abgetasteten Eingangsdaten zu speisende Überabtasteinrichtung (Oversampling-Einrichtung) (205) zur Erhöhung der Abtastfrequenz der abgetasteten Eingangsdaten um einen Faktor $2^k$ und zur Lieferung von überabgetasteten Daten,
   eine mit den genannten überabgetasteten Daten zu speisende Pufferspeichereinrichtung (206) zum temporären Speichern dieser Daten und zum Auslesen der gespeicherten überabgetasteten Daten mit einer Ausleserate, die durch das Verhältnis zwischen den Perioden der Eingangsabtastfrequenz und der Ausgangsabtastfrequenz bestimmt ist,
   eine Mittelwertbildungseinrichtung (209, 212, 213, 215, 216) zur Bildung des Mittelwerts der Perioden der Eingangsabtastfrequenz und zur Bildung des Mittelwerts der Perioden der Ausgangsabtastfrequenz während einer vorbestimmten Zeitspanne,
   eine Filterkoeffizientengeneratoreinrichtung (217), die auf den Mittelwert der Perioden der Eingangsabtastfrequenz und auf den Mittelwert der Perioden der Ausgangsabtastfrequenz anspricht, um Daten zu erzeugen, die einen Satz von vorbestimmten Filterkoeffizienten repräsentieren, welche aus einer Tiefpaßfilter-Impulsantwort abgeleitet sind,
   eine variable Filtereinrichtung (207) zur Aufnahme der aus der Pufferspeichereinrichtung (206) ausgelesenen überabgetasteten Daten und der von der Filterkoeffizientengeneratoreinrichtung erzeugten Filterkoeffizientendaten, um Abtastproben von umgesetzten Daten zu erzeugen, und
   eine Ausgabeeinrichtung (208) zur Lieferung der Abtastproben der umgesetzten Daten mit der Ausgangsabtastfrequenz.

2. Umsetzer nach Anspruch 1 mit einer Puffersteuereinrichtung (210) zur Erzeugung von Puffersteuersignalen, die der Pufferspeichereinrichtung (206) zuführbar sind, um das Auslesen von überabgetasteten Daten aus der Pufferspeichereinrichtung zu steuern.

3. Umsetzer nach Anspruch 1, bei dem die Mittelwertbildungseinrichtung eine lokale Taktgeneratoreinrichtung (209) zur Erzeugung eines lokalen Taktsignals aufweist, ferner eine erste Einrichtung (212) zum Bestimmen des relativen Verhältnisses zwischen der Periode der Eingangsabtastfrequenz und der Periode des lokalen Taktsignals, eine zweite Einrichtung (213) zum Bestimmen des relativen Verhältnisses zwischen der Periode der Ausgangsabtastfrequenz und der Periode des lokalen Taktsignals und eine erste und eine zweite Mittelwertbildungseinrichtung (215, 216) zur Bildung des Mittelwerts jedes der genannten Verhältnisse.

4. Abtastfrequenzumsetzer nach Anspruch 3,

   bei dem die erste Einrichtung (215) zur Mittelwertbildung aufweist:
   einen ersten Addierer (251), dem eine gemessene relative Zeitdifferenz zwischen einer Eingangsabtastperiode und der lokalen Taktperiode sowie ein Schätzwert der relativen Zeitdifferenz zwischen diesen Perioden zuführbar ist, so daß der genannte Addierer (251) einen Fehler zwischen der gemessenen und der geschätzten relativen Zeitdifferenz detektiert,
   eine Fehlerüberwachungseinrichtung (253), der der von dem ersten Addierer (251) detektierte Fehler zuführbar ist, zur Erzeugung eines Korrekturausgangssignals,
   einen zweiten Addierer (255), dem das Korrekturausgangssignal der Fehlerüberwachungseinrichtung (253) und ein von dem zweiten Addierer (255) erzeugter früherer Schätzwert der Eingangsabtastperiode zuführbar sind, zur Erzeugung eines korrigierten Schätzwerts der Eingangsabtastperiode, und
   einen dritten Addierer (252), dem der von dem zweiten Addierer (255) erzeugte korrigierte Schätzwert der Eingangsabtastperiode und ein früherer korrigierter Schätzwert zuführbar sind, um den genannten Schätzwert der relativen Zeitdifferenz zwischen der Eingangsabtastperiode und der lokalen Taktperiode zu erzeugen und diese dem ersten Addierer (251) zuzuführen.

5. Verfahren zum Umsetzen von abgetasteten Eingangsdaten mit einer Eingangsabtastfrequenz in abgetastete Ausgangsdaten mit einer ausgewählten Ausgangsabtastfrequenz, wobei das Verfahren folgende Schritte aufweist:

Überabtasten (Oversampling) (205) der abgetasteten Eingangsdaten zur Vergrößerung von deren Abtastfrequenz um einen Faktor $2^k$, um überabgetastete Daten bereitzustellen,

temporäres Speichern der überabgetasteten Daten und Auslesen der gespeicherten überabgetasteten Daten mit einer Ausleserate, die durch das Verhältnis zwischen der Periode der Eingangsabtastfrequenz und der Periode der Ausgangsabtastfrequenz bestimmt ist,

Bildung des Mittelwerts (209, 212, 213, 215, 216) der Perioden der Eingangsabtastfrequenz und Bildung des Mittelwerts der Perioden der Ausgangsabtastfrequenz während einer vorbestimmten Zeitspanne,

Erzeugen (217) von aus einer Tiefpaßfilter-Impulsantwort abgeleiteten vorbestimmten Filterkoeffizienten in Abhängigkeit von dem Mittelwert der Perioden der Eingangsabtastfrequenz und dem Mittelwert der Perioden der Ausgangsabtastfrequenz,

variables Filtern (207) der ausgelesenen überabgetasteten Daten durch Verarbeiten dieser Daten mit den Filterkoeffizienten, um Abtastproben von umgesetzten Daten zu erzeugen, und

Ausgeben (208) der Abtastproben der umgesetzten Daten mit der Ausgangsabtastfrequenz.

6. Verfahren nach Anspruch 5, bei dem der Verfahrensschritt der Mittelwertbildung folgende Schritte umfaßt:

Erzeugen (209) eines lokalen Taktsignals,

Bestimmen (212) des relativen Verhältnisses zwischen der Periode der Eingangsabtastfrequenz und der Periode des lokalen Taktsignals,

Bestimmen (213) des relativen Verhältnisses zwischen der Periode der Ausgangsabtastfrequenz und der Periode des lokalen Taktsignals und

Bildung des Mittelwerts (215, 216) jedes der beiden Verhältnisse.

7. Verfahren nach Anspruch 6, bei dem der Verfahrensschritt der Bildung des Mittelwerts des relativen Verhältnisses zwischen der Eingangsabtastperiode und der lokalen Taktperiode folgende Schritte umfaßt:

Addieren (251) einer gemessenen relativen Zeitdifferenz zwischen einer Eingangsabtastperiode und der lokalen Taktperiode sowie einer geschätzten relativen Zeitdifferenz zwischen diesen Perioden, um einen Fehler zwischen der gemessenen und der geschätzten relativen Zeitdifferenz zu detektieren,

Erzeugen (253) eines Korrekturausgangssignals nach Maßgabe des detektierten Fehlers,

Addieren (255) des Korrekturausgangssignals und eines früheren Schätzwertes der Eingangsabtastperiode, um einen korrigierten Schätzwerts der Eingangsabtastperiode zu erzeugen, und

Addieren (252) des korrigierten Schätzwerts der Eingangsabtastperiode und eines früheren korrigierten Schätzwerts, um den genannten Schätzwert der relativen Zeitdifferenz zwischen der Eingangsabtastperiode und der lokalen Taktperiode zu erzeugen,

wobei der korrigierte Schätzwert der Eingangsabtastperiode den Mittelwert des relativen Verhältnis zwischen der Eingangsabtastperiode und der lokalen Taktperiode darstellt.

## Revendications

1. Convertisseur de fréquence d'échantillonnage pour convertir des données d'entrée échantillonnées présentant une fréquence d'échantillonnage d'entrée selon des données de sortie échantillonnées présentant une fréquence d'échantillonnage de sortie sélectionnée, le convertisseur comprenant :

un moyen de sur-échantillonnage (205) connecté pour se voir appliquer lesdites données d'entrée échantillonnées pour augmenter la fréquence d'échantillonnage desdites données d'entrée échantillonnées d'un facteur de $2^k$ afin de produire des données sur-échantillonnées ;

un moyen de mémoire tampon (206) connecté pour se voir appliquer lesdites données sur-échantillonnées pour stocker temporairement celles-ci et pour lire les données sur-échantillonnées stockées à un taux de lecture déterminé par un rapport entre des périodes de ladite fréquence d'échantillonnage d'entrée et de ladite fréquence d'échantillonnage de sortie ;

un moyen de calcul de moyenne (209, 212, 213, 215, 216) pour calculer la moyenne des périodes de ladite fréquence d'échantillonnage d'entrée et pour calculer la moyenne des périodes de ladite fréquence d'échantillonnage de sortie pendant une durée temporelle prédéterminée ;

un moyen de génération de coefficient de filtre (217) sensible auxdites périodes moyennées de ladite fréquence d'échantillonnage d'entrée et auxdites périodes moyennées de ladite fréquence d'échantillonnage de sortie pour générer des données représentant un jeu de coefficients de filtre prédéterminés dérivé à partir d'une réponse impulsionnelle de filtre passe-bas ;

un moyen de filtre variable (207) pour recevoir les données sur-échantillonnées lues dans ledit moyen de mémoire tampon (206) et les données de coefficient de filtre générées par ledit moyen de génération de coefficient de filtre pour produire les échantillons de données convertis ; et

un moyen de sortie (208) pour appliquer des échantillons de données convertis à ladite fréquence d'échantillonnage de sortie.

2. Convertisseur selon la revendication 1, comprenant un moyen de commande de tampon (210) pour générer des signaux de commande de tampon destinés à être appliqués sur ledit moyen de mémoire tampon (206) afin de commander la lecture de données sur-échantillonnées dans ledit moyen de mémoire tampon.

3. Convertisseur selon la revendication 1, dans lequel ledit moyen de calcul de moyenne comprend un moyen de génération d'horloge locale (209) pour générer un signal d'horloge locale, un premier moyen (212) pour déterminer un rapport relatif entre la période de ladite fréquence d'échantillonnage d'entrée et la période dudit signal d'horloge locale, un second moyen (213) pour déterminer un rapport relatif entre la période de ladite fréquence d'échantillonnage de sortie et la période dudit signal d'horloge locale et des premier et second moyens de calcul de moyenne (215, 216) pour calculer la moyenne de chacun desdits rapports.

4. Convertisseur de fréquence d'échantillonnage selon la revendication 3, dans lequel ledit premier moyen de calcul de moyenne (215) inclut un premier additionneur (251) connecté pour se voir appliquer une différence temporelle relative mesurée entre une période d'échantillonnage d'entrée et ladite période d'horloge locale et une différence temporelle relative estimée entre elles de telle sorte que ledit additionneur (251) fonctionne pour déterminer une erreur entre les différences temporelles relatives mesurée et estimée, un moyen de surveillance d'erreur (253) connecté pour se voir appliquer l'erreur déterminée par ledit premier additionneur (251) pour produire une sortie de correction, un second additionneur (255) connecté pour se voir appliquer la sortie de correction dudit moyen de surveillance d'erreur (253) et une estimation précédente de la période d'échantillonnage d'entrée produite par ledit second additionneur (255) pour générer une estimation corrigée de la période d'échantillonnage d'entrée et un troisième additionneur (252) connecté pour se voir appliquer l'estimation corrigée de la période d'échantillonnage d'entrée générée par ledit second additionneur (255) et une estimation corrigée précédente pour générer ladite différence temporelle relative estimée entre ladite période d'échantillonnage d'entrée et ladite période d'horloge locale et pour appliquer celle-ci sur ledit premier additionneur (251).

5. Procédé de conversion de données d'entrée échantillonnées présentant une fréquence d'échantillonnage d'entrée selon des données de sortie échantillonnées présentant une fréquence d'échantillonnage de sortie sélectionnée, le procédé comprenant les étapes de :

sur-échantillonnage (205) des données d'entrée échantillonnées afin d'augmenter leur fréquence d'échantillonnage d'un facteur de $2^k$ afin de produire des données sur-échantillonnées ;

stockage temporaire (206) des données sur-échantillonnées et lecture des données sur-échantillonnées stockées à un taux de lecture déterminé par un rapport entre la période de ladite fréquence d'échantillonnage d'entrée et la période de ladite fréquence d'échantillonnage de sortie ;

calcul de moyenne (209, 212, 213, 215, 216) des périodes de ladite fréquence d'échantillonnage d'entrée et des périodes de ladite fréquence d'échantillonnage de sortie pendant une durée temporelle prédéterminée ;

génération (217) de coefficients de filtre prédéterminés dérivés à partir d'une réponse impulsionnelle de filtre passe-bas en réponse aux périodes moyennées de ladite fréquence d'échantillonnage d'entrée et aux périodes moyennées de ladite fréquence d'échantillonnage de sortie ;

filtrage variable (207) des données sur-échantillonnées lues en les traitant à l'aide des coefficients de filtre pour produire des échantillons de données convertis ; et

application (208) des échantillons de données convertis à ladite fréquence d'échantillonnage de sortie.

6. Procédé selon la revendication 5, dans lequel l'étape de calcul de moyenne comprend la génération (209) d'un signal d'horloge locale, la détermination (212) d'un rapport relatif entre la période de ladite fréquence d'échantillonnage d'entrée et la période dudit signal d'horloge locale, la détermination (213) d'un rapport relatif entre la période de ladite fréquence d'échantillonnage de sortie et la période dudit signal d'horloge locale et le calcul de moyenne (215, 216) de chacun desdits rapports.

**7.** Procédé selon la revendication 6, dans lequel l'étape de calcul de moyenne du rapport relatif entre la période d'échantillonnage d'entrée et la période d'horloge locale comprend l'addition (251) d'une différence temporelle relative mesurée entre la période d'échantillonnage d'entrée et la période d'horloge locale et d'une différence temporelle relative estimée entre elles afin de détecter une erreur entre les différences temporelles relatives mesurée et estimée, la production (253) d'une sortie de correction en réponse à l'erreur détectée, l'addition (255) de la sortie de correction et d'une estimation précédente de la période d'échantillonnage d'entrée pour générer une estimation corrigée de la période d'échantillonnage d'entrée et l'addition (252) de l'estimation corrigée de la période d'échantillonnage d'entrée et d'une estimation corrigée précédente pour produire ladite différence temporelle relative estimée entre ladite période d'échantillonnage d'entrée et ladite période d'horloge locale ; et dans lequel l'estimation corrigée de la période d'échantillonnage d'entrée est le rapport relatif moyenné entre la période d'échantillonnage d'entrée et la période d'horloge locale.

# FIG. 1

# FIG. 2

# FIG. 3

# FIG. 4

Impulse Response of LPF

# FIG. 5

# FIG. 6

# FIG. 7

# FIG. 8

# FIG. 9

# FIG. 10

EP 0 599 817 B1

X₁    X₂    X₃    X₄    X₅    X₆    X₇    X₈    X₉    X₁₀

A₁(0.1)   A₂(0.35)   A₃(0.6)   A₄(0.85)   A₁(0.2)   A₂(0.45)   A₃(0.7)   A₄(0.95)

A₁(0.05)   A₂(0.3)   A₃(0.55)

# F I G. II

FIG. 12

EP 0 599 817 B1

# FIG. 13

# FIG. 14

# FIG. 15

# FIG. 16

# FIG. 17

# FIG. 18

Estimated Sample Position

To

$-\Delta(Ts_1/To)$  $+\Delta(Ts_1/To)$